# EUROPEAN PATENT APPLICATION

(11) **EP 1 727 209 A2**
(43) Date of publication of application: **29.11.2006**
(21) Application number: 06010743.0
(22) Date of filing: 24.05.2006
(51) Int. Cl.: H01L 29/872, H01L 29/24

(54) **Schottky barrier diode and method of producing the same**

(30) Priority: 25.05.2005 JP 2005152167
(71) Applicant: Ecotron Co., Ltd., Ukyo-ku Kyoto-shi Kyoto 615-8686 (JP)
(72) Inventor: Kawami, Hiroshi, Kyoto-shi Kyoto 615-8686 (JP)
(74) Representative: Grünecker, Kinkeldey, Stockmair & Schwanhäusser Anwaltssozietät

(57) **Abstract**

An epitaxial layer 12 is formed on a semiconductor substrate 11 comprising silicon carbide, a Schottky electrode 14 is formed on a surface of the epitaxial layer 12, a noble metal contact electrode 15 is formed on the Schottky electrode 14, and after the formation of this contact electrode 15, heat treatment is conducted at a temperature of from 600 to 1000°C.

## Description

### BACKGROUND OF THE INVENTION

### 1. Technical Field

The present disclosure relates to a Schottky barrier diode which is a semiconductor device having a Schottky junction using silicon carbide (SiC), and a method of producing the Schottky barrier diode.

### 2. Related Art

since silicon carbide (SiC) has large maximum electric field strength, it is expected of applications to semiconductor devices for power use whereby a large electric power and a high voltage resistance are controlled. As an example of such semiconductor devices using silicon carbide, there is a Schottky barrier diode (Refer to, for example, Japanese Patent Laid-Open No. 2000-164528) . This type of Schottky barrier diode is different from pn-junction diode in that it does not use minority carriers, and thus is capable of high-speed switching.

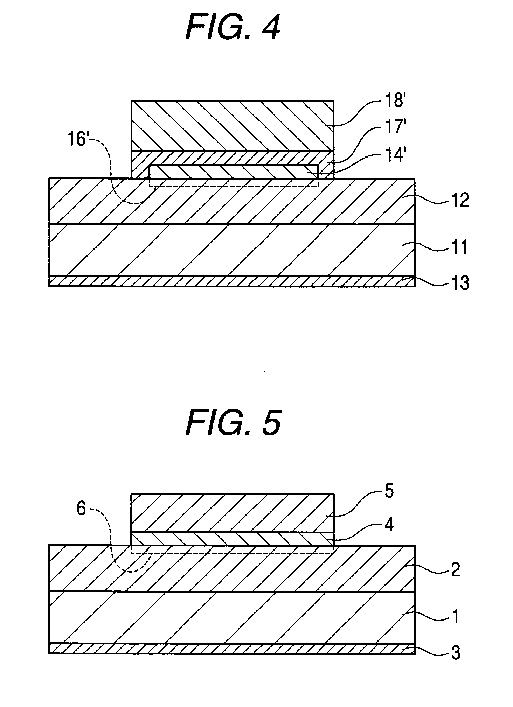

Fig. 5 is a schematic cross-sectional view showing a structural example of the Schottky barrier diode. As shown in the figure, the Schottky barrier diode has a structure in which an epitaxial layer 2 is formed on a semiconductor substrate 1 comprising silicon carbide (SiC) , a Schottky electrode 4 comprising Ti is formed on the surface of the epitaxial layer 2, and a contact electrode 5 made of Al or Cu is formed on the Schottky electrode 4. Meanwhile, on the rear surface of the semiconductor substrate 1, an ohmic electrode 3 made of Ni is provided.

This type of Schottky barrier diode is fabricated by forming the epitaxial layer 2 on the semiconductor substrate 1 comprising silicon carbide, and after forming the Schottky electrode 4 on the surface of the epitaxial layer 2 by sputtering or vapor-depositing Ti, and forming the contact electrode 5 on the Schottky electrode 4 by sputtering or vapor-depositing Al or Cu. After the formation of this contact electrode 5, an alloy layer 6 is formed at the interface between the epitaxial layer 2 and the Schottky electrode 4 by conducting heat treatment at a temperature lower than, for example, 600°C to stabilize the interface.

In the afore-mentioned Schottky barrier diode, Ti and Si react at the interface between the Schottky electrode 4 and the epitaxial layer 2 by heat treatment to form the alloy layer 6. By forming such an alloy layer 6, the interface between the Schottky electrode 4 and the epitaxial layer 2 are stabilized. As a result, the diode has a resistance to the heat generating when a surge voltage in the reverse direction is applied to the diode, and therefore improved reliability is attained. However, for heat treatment at a temperature lower than 600°C, alloy formation between Ti and Si is not enough whereby stabilization of the interface between the Schottky electrode 4 and the epitaxial layer 2 becomes difficult and thus it becomes difficult to provide resistance to the heat generating during surge voltage application.

In addition, in the case where the Schottky electrode 4 is formed with Ti, the Schottky barrier of silicon carbide is lower than those of other metals, whereby it is known that, due to a low on-voltage, the loss is reduced. However, in the case where the heat treatment is conducted only with the Schottky electrode 4, oxidation of Ti proceeds to raise the Schottky barrier whereby the loss increases. Alternatively, in the case where the heat treatment is conducted at an elevated temperature of 600°C or higher, the leakage current in the reverse direction increases, thus deteriorating the diode characteristics. Moreover, in the case where heat treatment is conducted under the condition that the contact electrode 5 comprising Al or Cu is provided on this Schottky electrode 4, the loss can be reduced without accompanying deterioration of the Schottky electrode 4 due to the oxidation of Ti, thus not raising the Schottky barrier. However, Ti reacts with Al or Cu, causing the leakage current to increase whereby a problem of diode characteristics deterioration occurs similarly to the case of heat treatment only with the Schottky electrode 4.

### SUMMARY OF THE INVENTION

The disclosure below describes a Schottky barrier diode and a method of producing the same, both being capable of preventing the deterioration of diode characteristics even when heat treatment is conducted under the condition where a contact electrode is provided on a Schottky electrode.

In one aspect, the disclosure describes a Schottky barrier diode comprising: a semiconductor substrate comprising silicon carbide; an epitaxial layer formed on the semiconductor substrate; and a Schottky electrode formed on a surface of the epitaxial layer. The Schottky barrier diode comprises a noble metal contact electrode formed on the aforementioned Schottky electrode or a noble metal intermediate electrode formed on the Schottky electrode and a contact electrode formed on the intermediate electrode.

Moreover, in another aspect, the disclosure describes a method of producing a Schottky barrier diode comprising steps of: forming an epitaxial layer on a semiconductor substrate comprising silicon carbide; and forming a Schottky electrode on a surface of the epitaxial layer. The method producing the Schottky barrier diode comprises steps of: forming a noble metal contact electrode on the Schottky electrode; and carrying out heat treatment at a temperature of from 600 to 1000°C after the step of forming the noble metal contact electrode, or forming a noble metal intermediate electrode on the Schottky electrode; forming a contact electrode on the intermediate electrode ; and carrying out heat treatment at a temperature of from 600 to 1000°C,

Since the noble metal contact electrode or the noble metal intermediate electrode is formed on the Schottky electrode, reaction of Ti with the noble metal is mitigated even when the heat treatment is carried out under the condition where the contact electrode or the intermediate electrode is provided on the Schottky electrode. Thus, the leakage current is reduced, preventing deterioration of the diode characteristics.

As a result, it has become possible to carry out heat treatment at an elevated temperature as high as 600°C or higher after the formation of the contact electrode, whereby the alloy formation at the interface between the Schottky electrode and the epitaxial layer proceeds to a sufficient degree, thus easily stabilizing the interface by imparting a resistance to the heat generating during the application of surge voltage in the reverse direction. When the temperature for this heat treatment is higher than 1000°C, the alloy formation at the interface between the Schottky electrode and the epitaxial layer proceeds excessively, resulting in deterioration of the diode characteristics.

Various implementations may include one or more the following advantages. For example, since a noble metal contact electrode or a noble metal intermediate electrode is formedona Schottky electrode, reaction of Ti with the noble metal is mitigated even when heat treatment is carried out under the condition where the contact electrode or the intermediate electrode is formed on the Schottky electrode. Thus, leakage current is reduced, preventing the diode characteristics from deterioration.

As a result, by carrying out heat treatment at an elevated temperature of from 600°C to 1000°C after the formation of the contact electrode, the alloy formation at the interface between the Schottky electrode and the epitaxial layer proceeds to a sufficient degree, thus readily achieving stabilization of the interface by imparting a resistance to the heat generating during the application of surge voltage in the reverse direction.

Since deterioration of the diode characteristics can be suppressed in the aforementioned manner, and can impart resistance to the heat generating during the application of the surge voltage in the reverse direction, a stable operation at an elevated temperature can be achieved, and thus a highly reliable Schottky barrier diode can be provided.
Other features and advantages may be apparent from the following detailed description, the accompanying drawings and the claims.

### BRIEF DESCRIPTION OF THE DRAWINGS

Fig. 1 is one embodiment of the invention and is a schematic cross-sectional view showing the structural example of the Schottky barrier diode provided with a noble metal contact electrode.
Fig. 2 is another embodiment of the invention and is a schematic cross-sectional view showing the structural example of the Schottky barrier diode provided with a noble metal intermediate electrode.
Fig. 3 is another embodiment of the invention and a schematic cross-sectional view showing a modification of the Schottky barrier diode in Fig. 1.
Fig. 4 is another embodiment of the invention and is a schematic cross-sectional view showing a modification of the Schottky barrier diode in Fig. 2.
Fig. 5 is a schematic cross-sectional view showing the structural example of a related-art Schottky barrier diode.

### DETAILED DESCRIPTION OF THE INVENTION

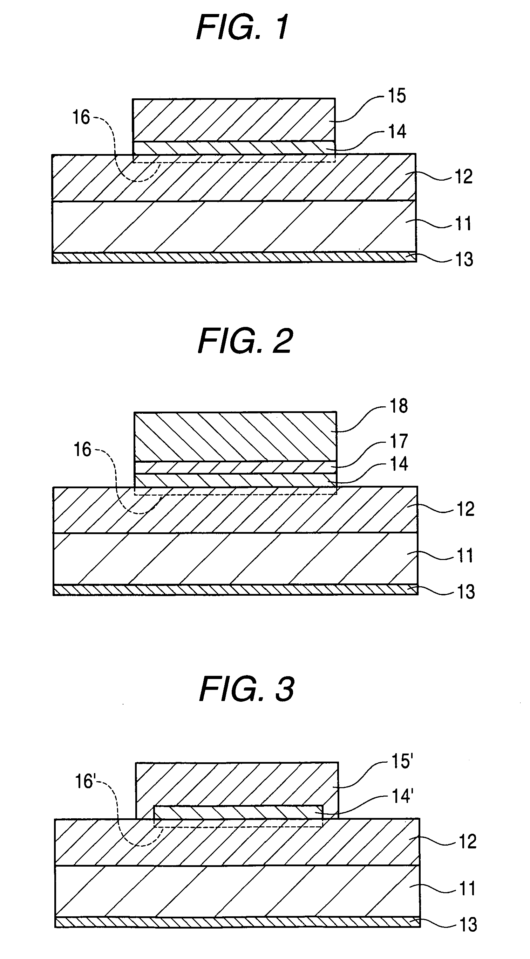

Fig. 1 is a schematic cross-sectional view showing a structural example of the Schottky barrier diode as an embodiment of the invention. As shown in the figure, the Schottky barrier diode of this embodiment comprises an epitaxial layer 12 formed on a semiconductor substrate 11 comprising silicon carbide (SiC), a Schottky electrode 14 made of Ti formed on a surface of the epitaxial layer 12, and a noble metal contact electrode 15 formed on the Schottky electrode 14. Meanwhile, on the rear surface of the semiconductor substrate 11, an ohmic electrode 13 made of Ni is formed. As the noble metal forming this contact electrode 15, Au, Pt, Ag, Pd or Ir can be used.
This type of Schottky barrier diode can be fabricated in the following manner. First of all, an n-type epitaxial layer 12 is formed on an n-type semiconductor substrate 11 comprising silicon carbide (SiC). As this epitaxial layer 12, for example, those with a thickness of about 10 µm are preferred. Moreover, the carrier density of the semiconductor substrate 11 is 1 x 10¹⁸ cm⁻³, and the carrier density of the epitaxial layer 12 is 5 x 10¹⁵ cm⁻³.

On the rear surface of the aforementioned semiconductor substrate 11, the ohmic electrode 13 is formed by vapor-depositing Ni to a thickness of 0.1 µm, followed by heat treatment. Thereafter, as a pre-treatment for the formation of a Schottky electrode, after rinsing of the semiconductor substrate 11, the surface of the epitaxial layer 12 is subjected to sputtering with Ti and Au in this order. The sputtering condition is controlled so as to give a Ti layer thickness of 0.2 µm and an Au layer thickness of 2.0 µm. After the formation of the Ti layer and the Au layer, patterning is conducted for the Au layer and then for the Ti layer by photo-lithography to form the Schottky electrode 14 made of Ti and the contact electrode 15 made of Au in a state that they are stacked on the epitaxial layer 12.

After the formation of this contact electrode 15, heat treatment is conducted in an inert gas atmosphere such as of Ar at an elevated temperature of, for example, 700°C for 30 min. This heat treatment is desirably carried out in the temperature range of from 600 to 1000°C. Through this heat treatment, an alloy layer 16 is formed at the interface between the epitaxial layer 12 and the Schottky electrode 14 with the intention of making the interface stabilized. As a result, the interface can have resistance to the heat generating during the application of surge voltage in the reverse direction. Further, during this heat treatment, deterioration of the Schottky electrode 14 due to the oxidation of Ti does not occur, since the Ti Schottky electrode 14 is covered with the Au contact electrode 15. Accordingly, the leakage current does not increase and the Schottky barrier will not rise, thus achieving loss reduction.

When the heat-treatment temperature is lower than 600°C, the alloy formation at the interface between the epitaxial layer 12 and the Schottky electrode 14 does not proceed to a sufficient degree, whereby it becomes difficult to stabilize the interface and thus to impart resistance to the heat generating during the application of surge voltage in the reverse direction. On the other hand, when the heat-treatment temperature is higher than 1000°C, the alloy formation at the interface between the Schottky electrode 14 and the epitaxial layer 12 proceeds excessively, resulting in deterioration of the diode characteristics.

Next, Fig. 2 is a schematic cross-sectional view showing a structural example of the Schottky barrier diode in another embodiment of the invention. As shown in the figure, the Schottky barrier diode of this embodiment comprises a Schottky electrode 14 made of Ti formed on a surface of an epitaxial layer 12 formed on a semiconductor substrate 11 comprising silicon carbide, and an intermediate electrode 17 made of Au and a contact electrode 18 made of Al are formed on the Schottky electrode 14.

The production process for this type of Schottky barrier diode comprises forming the epitaxial layer 12 on the semiconductor substrate 11 comprising silicon carbide in the same manner as in the aforementioned embodiment shown in Fig. 1., and sputtering Ti, Au and Al on the surface of the epitaxial layer 12 in this order. The thicknesses attained by these sputtering operations are 0.2 µm for Ti, 0.2 µm for Au and 2.0 µm for Al, respectively. After the formation of these Ti, Au and Al coatings, patterning by photo-lithography is conducted for each of Al, Au and Ti coatings in this order, thereby forming the Schottky electrode 14 made of Ti, the intermediate electrode 17 made of Au and the contact electrode 18 made of Al in a state that they are stacked on the epitaxial layer 12. After the formation of this contact electrode 18, heat treatment is conducted in the same manner as in the embodiment illustrated in Fig. 1.

In the case of the present embodiment, the noble metal intermediate electrode 17 is formed thin, on which the contact electrode 18 made of Al or Cu is provided in a large thickness, thus enabling the reduction of the use amount of the noble metal to save the cost of the product.

Meanwhile, in the aforementioned embodiment shown in Fig. 1, the side plane of the Schottky electrode 14 made of Ti is exposed. But, by covering the side plane of the Schottky electrode 14' made of Ti with a contact electrode 15' made of Au as shown in Fig. 3, deterioration of the Schottky electrode 14' made of Ti can be prevented. Further, in the embodiment illustrated in Fig. 2, the side plane of the Schottky electrode 14 of Ti is exposed, too. But, by covering the side plane of the Schottky electrode 14' made of Ti with an intermediate electrode 17' made of Au as shown in Fig. 4, deterioration of the Schottky electrode 14' made of Ti can be prevented.
It will be apparent to those skilled in the art that various modifications and variations can be made to the described preferred embodiments of the present invention without departing from the spirit or scope of the invention. Thus, it is intended that the present invention cover all modifications and variations of this invention consistent with the scope of the appended claims and their equivalents.

## Claims

1. A Schottky barrier diode comprising:
a semiconductor substrate comprising silicon carbide;
an epitaxial layer formed on the semiconductor substrate; a Schottky electrode formed on a surface of the epitaxial layer; and
a noble metal contact electrode formed on the Schottky electrode.

2. A Schottky barrier diode comprising:
a semiconductor substrate comprising silicon carbide;
an epitaxial layer formed on the semiconductor substrate; a Schottky electrode formed on a surface of the epitaxial layer, a noble metal intermediate electrode formed on the Schottky electrode; and
a contact electrode formed on the intermediate electrode.

3. A method of producing a Schottky barrier diode comprising steps of:
forming an epitaxial layer on a semiconductor substrate comprising silicon carbide;
forming a Schottky electrode on a surface of the epitaxial layer;
forming a noble metal contact electrode on the Schottky electrode; and
carrying out heat treatment at a temperature of from 600 to 1000°C after the step of forming the contact electrode.

4. A method of producing a Schottky barrier diode comprising steps of:
forming an epitaxial layer on a semiconductor substrate comprising silicon carbide;
forming a Schottky electrode on a surface of the epitaxial layer;
forming a noble metal intermediate electrode on the Schottky electrode;
forming a contact electrode on the intermediate electrode; and
carrying out a heat treatment at a temperature of from 600 to 1000°C after the step of forming the contact electrode.
